# EUROPEAN PATENT APPLICATION

(11) **EP 2 918 654 A2**
(43) Date of publication of application: **16.09.2015**
(21) Application number: 15155938.2
(22) Date of filing: 20.02.2015
(51) Int. Cl.: C09K 11/08, C09K 11/77

(54) **Phosphor, method for producing the same, and light-emitting device employing the same**

(30) Priority: 12.03.2014 JP 2014049438; 02.02.2015 JP 2015018726
(71) Applicant: Kabushiki Kaisha Toshiba, Tokyo 105-8001 (JP)
(72) Inventor: Okada, Aoi, Tokyo 105-8001 (JP); Kato, Masahiro, Tokyo 105-8001 (JP); Hattori, Yasushi, Tokyo 105-8001 (JP)
(74) Representative: Hoffmann Eitle

(57) **Abstract**

The embodiment of the present disclosure provides a phosphor exhibiting an emission peak in the wavelength range of 500 to 600 nm under excitation by light having a peak in the wavelength range of 250 to 500 nm. This phosphor is in the form of particles having a median size of 5 to 40 µm inclusive, shows a luminous efficiency of more than 70%, and has a composition represented by the following formula (1):

((SrₚM₁₋ₚ)₁₋ₓCeₓ)_{2y}Al_{z}Si_{10-z}OᵤN_{w} (1).

In the formula, M is at least one of the alkaline earth metals, and p, x, y, z, u and w satisfy the conditions of
0≤p≤1,
0<x≤1,
0.8≤y≤1.1,
2≤z≤3.5,
0<u≤1,
1.5≤z-u, and
13≤u+w≤15, respectively.

## Description

### FIELD

Embodiments of the present disclosure relate to a phosphor, a method for producing the phosphor, and a light-emitting device employing the phosphor.

### BACKGROUND

A white light-emitting device comprises a combination of, for example, a blue LED, a phosphor that emits red light under excitation by blue light, and another phosphor that emits green light under excitation by blue light. However, if containing a phosphor that emits yellow light under excitation by blue light, the white light-emitting device can be produced by use of fewer kinds of phosphors. As the yellow-light emitting phosphor, a Eu-activated orthosilicate phosphor is known, for example.

The yellow-light emitting phosphor used in the white light-emitting device is required to be in the form of small particles and also to have high efficiency.

### BRIEF DESCRIPTION OF THE DRAWINGS

Figures 1A to 1C show the crystal structure of Sr₂Al₃Si₇ON₁₃.
Figure 2 shows a sectional view schematically illustrating the constitution of a light-emitting device according to an embodiment.
Figure 3 shows a sectional view schematically illustrating the constitution of a light-emitting device according to another embodiment.
Figure 4 shows an emission spectrum of the phosphor produced in Example 1.
Figure 5 shows an emission spectrum of the phosphor produced in Example 2.
Figure 6 shows an emission spectrum of the phosphor produced in Example 3.
Figure 7 shows an emission spectrum of the phosphor produced in Comparative example 1.
Figure 8 shows particle size distribution of the phosphors produced in Examples and Comparative example.
Figure 9 shows relation between the particle size and the luminous efficiency in Examples and Comparative example.

### DETAILED DESCRIPTION

Embodiments will now be explained with reference to the accompanying drawings.

The phosphor according to the embodiment exhibits an emission peak in the wavelength range of 500 to 600 nm under excitation by light having a peak in the wavelength range of 250 to 500 nm, and hence can emit light in yellowish green to orange color range. Since thus radiating light mainly in yellow range, the phosphor of the embodiment is hereinafter referred to as a "yellow light-emitting phosphor". This phosphor has a matrix of essentially the same crystal structure as that of Sr₂Al₃Si₇ON₁₃, and the matrix is activated by Ce. Specifically, the yellow light-emitting phosphor according to the embodiment is represented by the following formula (1):

((SrₚM₁₋ₚ)₁₋ₓCeₓ)_{2y}Al_{z}Si_{10-z}OᵤN_{w} (1)

In the formula, M is at least one of the alkaline earth metals, and p, x, y, z, u and w satisfy the conditions of
0≤p≤1,
0<x≤1,
0.8≤y≤1.1,
2≤z≤3.5,
0<u≤1,
1.5≤z-u, and
13≤u+w≤15, respectively.

As shown in the above formula (1), the metal elements constituting the phosphor crystal are partly replaced with the emission center element Ce. The metal element M is at least one of the alkaline earth metals, and preferably may be replaced with at least one element selected from the group consisting of Ba, Ca and Mg. If p is 0.85 or more, preferably 0.9 or more, formation of other phases is not promoted. In some cases, p is preferably 1 so as to optimize luminescent properties of the phosphor. However, even in those cases, metal elements other than Sr or Ce may be contained as unavoidable impurities. The phosphor of that crystal generally shows the effect of the present embodiment sufficiently. If containing Ce in an amount of 0.1 mol% or more based on the total of Sr, M and Ce, the phosphor can have sufficient luminous efficiency. It is possible to omit Sr and M (that is, x may be 1), but decrease of the emission probability (concentration quenching) can be avoided to the utmost if x is less than 0.5. Accordingly, x is preferably 0.001 to 0.5 inclusive. The phosphor of the embodiment contains Ce as an emission center, and thereby emits light in the range of yellowish green to orange, namely, luminescence with a peak in the wavelength range of 500 to 600 nm, under excitation by light with a peak in the wavelength range of 250 to 500 nm. Even if other elements such as Tb, Eu and Mn are contained as unavoidable impurities in an amount of about 15 at.% or less, preferably 10 at.% or less, based on the amount of Ce, they do not impair the aimed properties.

If y is less than 0.8, crystal defects are increased to lower the efficiency. On the other hand, if y is more than 1.1, excess of the alkaline earth metal may deposit in the form of other phases to deteriorate the luminescent properties. Accordingly, y is preferably 0.85 to 1.06 inclusive.

If z is less than 2, excess Si may deposit in the form of other phases to deteriorate the luminescent properties. On the other hand, if z is more than 3.5, excess Al may deposit in the form of other phases to deteriorate the luminescent properties. Accordingly, z is preferably 2.1 to 3.3 inclusive.

If u is more than 1, crystal defects are increased to lower the efficiency. Accordingly, u is preferably 0.001 to 0.8 inclusive.

If the value of z-u is less than 1.5 or if the value of u+w is less than 13 or more than 15, the phosphor of the embodiment often cannot keep the crystal structure regulated in the embodiment and occasionally other phases are formed, so that the effect of the embodiment cannot be obtained. Accordingly, the values of z-u and u+w are preferably 2 or more and 13.2 to 14.2 inclusive, respectively.

Since satisfying all the above conditions, the phosphor according to the present embodiment can efficiently emit yellow light under excitation by light with a peak in the wavelength range of 250 to 500 nm.

The yellow light-emitting phosphor of the embodiment is based on Sr₂Al₃Si₇ON₁₃, but its constituent elements Sr, Si, Al, O and N can be replaced with other elements and/or Ce to form a solid solution with the matrix. In the present embodiment, this kind of phosphor is referred to as a "Sr₂Al₃SbON₁₃-type crystal". These modifications, such as replacement, often change the crystal structure. However, the atomic positions therein are only slightly changed so that the chemical bonds do not break. Here, the atomic positions depend on the crystal structure, on the sites occupied by the atoms therein and on their atomic coordinates.

The embodiment of the present disclosure leads to the aimed effect as long as the yellow-light emitting phosphor does not change its basic crystal structure. There may be a case where the crystal structure of the phosphor differs from that of Sr₂Al₃Si₇ON₁₃ in the lattice constants and/or in the chemical bond lengths (close interatomic distances) of M-N and M-O. However, even in that case, if the differences are within a range of ±15% based on the lattice constants or chemical bond lengths (Sr-N and Sr-O) in Sr₂Al₃Si₇ON₁₃, the crystal structure is defined to be the same. Here, the lattice constants can be determined by X-ray diffraction or neutron diffraction, and the chemical bond lengths (interatomic distances) of M-N and M-O can be calculated from the atomic coordinates.

The Sr₂Al₃Si₇ON₁₃ crystal belongs to a monoclinic system, especially to an orthorhombic system with lattice constants of, for example, a=11.8 Å, b=21.6 Å and c=5.01 Å. This crystal belongs to the space group Pna21. The chemical bond lengths (Sr-N and Sr-O) in Sr₂Al₃Si₇ON₁₃ can be calculated from the atomic coordinates shown in Table 1.

**Table 1**

| | site | occupancy | x | y | z |
|---|---|---|---|---|---|
| Sr1 | 4a | 1 | 0.2786 | 0.49060(11) | 0.5284(14) |
| Sr2 | 4a | 1 | 0.3552(3) | 0.69839(12) | 0.048(2) |
| Si/Al | 4a | 1 | 0.3582(9) | 0.2769(3) | 0.070(3) |
| Si/Al2 | 4a | 1 | 0.5782(9) | 0.7996(4) | 0.047(5) |
| Si/Al3 | 4a | 1 | 0.5563(8) | 0.4672(3) | 0.543(5) |
| Si/Al4 | 4a | 1 | 0.4724(8) | 0.6092(3) | 0.556(4) |
| Si/Al5 | 4a | 1 | 0.1910(7) | 0.6397(3) | 0.535(4) |
| Si/Al6 | 4a | 1 | 0.0061(8) | 0.5438(3) | 0.546(4) |
| Si/Al7 | 4a | 1 | 0.1625(9) | 0.5661(3) | 0.038(4) |
| Si/Al8 | 4a | 1 | 0.3937(8) | 0.3469(3) | 0.547(4) |
| Si/Al9 | 4a | 1 | 0.1552(18) | 0.3483(8) | 0.318(3) |
| Si/Al10 | 4a | 1 | 0.1525(14) | 0.3492(6) | 0.813(2) |
| O/N1 | 4a | 1 | 0.436(2) | 0.8164(10) | 0.061(11) |
| O/N2 | 4a | 1 | 0.699(2) | 0.4692(10) | 0.513(10) |
| O/N3 | 4a | 1 | 0.334(2) | 0.6355(10) | 0.511(9) |
| O/N4 | 4a | 1 | 0.213(2) | 0.2980(11) | 0.056(12) |
| O/N5 | 4a | 1 | 0.256(2) | 0.3750(10) | 0.563(9) |
| O/N6 | 4a | 1 | 0.894(2) | 0.6002(12) | 0.549(14) |
| O/N7 | 4a | 1 | 0.358(3) | 0.2062(12) | 0.893(6) |
| O/N8 | 4a | 1 | 0.508(2) | 0.4677(12) | 0.885(6) |
| O/N9 | 4a | 1 | 0.398(2) | 0.2727(12) | 0.392(6) |
| O/N10 | 4a | 1 | 0.430(3) | 0.3336(15) | 0.896(7) |
| O/N11 | 4a | 1 | 0.942(3) | 0.4814(15) | 0.371(8) |
| O/N12 | 4a | 1 | 0.662(2) | 0.8571(12) | 0.893(6) |
| O/N13 | 4a | 1 | 0.128(3) | 0.5743(15) | 0.381(7) |
| O/N14 | 4a | 1 | 0.495(3) | 0.3982(13) | 0.383(6) |

The yellow light-emitting phosphor according to the embodiment needs to have the above crystal structure. If the chemical bond lengths are largely changed from the above, they can be broken to form another crystal structure and hence the effect of the present embodiment cannot be obtained.

The yellow light-emitting phosphor of the present embodiment is based on an inorganic compound having the same crystal structure as Sr₂Al₃Si₇ON₁₃, but the constituent element M is partly replaced with the emission center element Ce and the amount of each element is restricted. On those conditions, the phosphor according to the present embodiment has favorable properties, such as, high quantum efficiency.

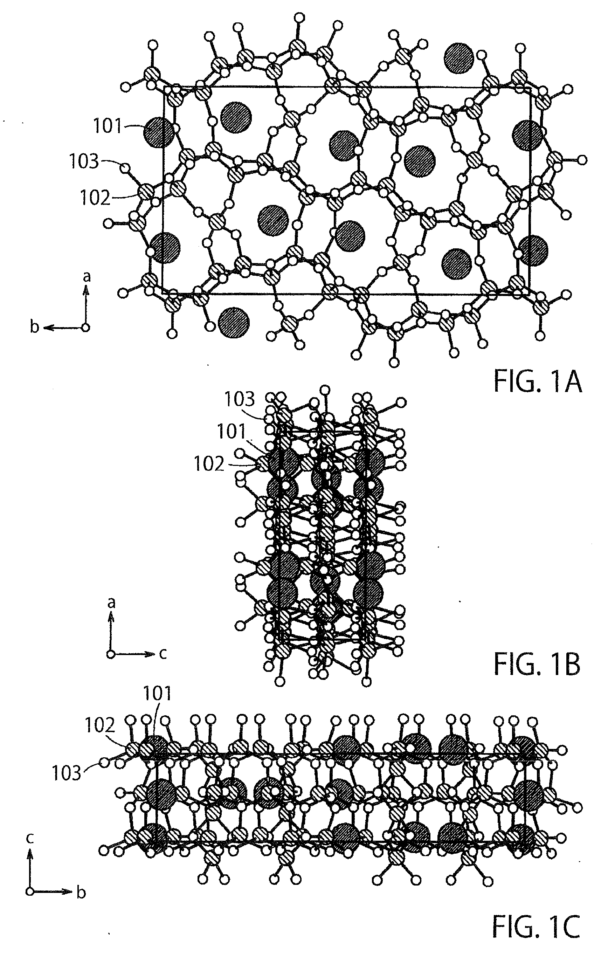

The crystal structure of Sr₂Al₃Si₇ON₁₃ based on the atomic coordinates in Table 1 is illustrated in Figure 1. Figures 1(a), (b) and (c) are projections of the crystal structure along the c, b and a axes, respectively. In Figures, 101 represents a Sr atom, which is surrounded by a Si or an Al atom 202 and an O or a N atom 103. The Sr₂Al₃Si₇ON₁₃ crystal can be identified by XRD or neutron diffraction.

The yellow light-emitting phosphor of the embodiment is characteristically in the form of particles having a size of 5 to 40 µm inclusive, preferably 10 to 38 µm inclusive. Since being in the form of small particles, the phosphor of the embodiment has the advantage of improving the production yield of the light-emitting device. That is because a composition containing the phosphor can be supplied from a dispenser without choking and also because the phosphor particles hardly precipitate in the composition. Further, the small phosphor particles tend to be distributed evenly in the luminescent layer of the produced light-emitting device, and accordingly the device advantageously emits light less suffering from color unevenness.

Crystals of the yellow light-emitting phosphor according to the embodiment are generally in the columnar shape. The size of those crystals can be measured by means of a commercially available particle size distribution measuring instrument, such as, a laser diffraction sensor HELOS&RODOS ([trademark], manufactured by Sympatec GmbH). If the phosphor particles agglomerate to form lumps, they are crushed softly enough not to destroy the crystal structure before the measurement is carried out. In the present embodiment, the "size" of the particles means a median size (D50).

The yellow light-emitting phosphor of the embodiment is also characterized by having a luminous efficiency of more than 70%. The reason why the phosphor of the embodiment shows high luminous efficiency is thought to be because of being in the form of small particles and of having a homogeneous crystal structure.

In the present embodiment, the luminous efficiency is measured under excitation by light at the wavelength of 450 nm. Specifically, for example, a xenon lamp is adopted as a light source and light from the lamp is resolved with a monochromator to obtain light of 450 nm. The luminous efficiency of the phosphor according to the embodiment is thus measured to be more than 70%, preferably more than 72%, further preferably more than 74%.

The yellow light-emitting phosphor of the embodiment can be produced in any manner. For example, it can be obtained by the steps of mixing the raw materials containing the above elements and then firing the mixture.

The material containing Sr can be selected from a silicide, a nitride, a carbide or carbonate of Sr; the material containing M can be selected from a nitride, a silicide, a carbide or a carbonate of M; the material containing Al can be selected from a nitride, an oxide or a carbide of Al; the material containing Si can be selected from a nitride, an oxide or a carbide of Si; and the material containing the emission center Ce can be selected from a chloride, an oxide, a nitride or a carbonate of Ce.

In addition, nitrogen can be supplied from the above nitrides or from a nitrogen-containing firing atmosphere, and oxygen can be supplied from the above oxides or from the oxidized surface of the above nitrides particles.

Specifically, for example, Sr₃N₂, CeCl₃, Si₃N₄ and AIN are mixed in appropriate amounts to give the aimed composition. Sr₃N₂ may be replaced with Sr₂N, SrN, SrC₂, SrSi₂ or its mixture. The materials are mixed, for example, in a mortar placed in a glove box. The mixed powder is laid in a crucible and then fired on particular conditions to obtain the phosphor of the embodiment. There are no particular restrictions in the materials of the crucible, which is made of, for example, boron nitride, silicon nitride, silicon carbide, carbon, aluminum nitride, SiAlON, aluminum oxide, molybdenum or tungsten.

The mixed powder is preferably fired under a pressure not less than the atmospheric pressure. Since the silicon nitride decomposes easily, it is advantageous to fire the mixture under a pressure not less than the atmospheric pressure. In order to prevent the silicon nitride from decomposition at a high temperature, the pressure (absolute pressure)is preferably 5 atm or more and the firing temperature is preferably in the range of 1400 to 2000°C. If those conditions are satisfied, the aimed fired product can be obtained without suffering from troubles such as sublimation of the raw materials and/or of the product. As described later, if there are two or more firing steps in the production process, they are preferably throughout or partly carried out under an increased pressure. It is particularly preferred to carry out the firing steps throughout under an increased pressure.

The method for producing the phosphor of the embodiment preferably comprises two or more firing steps carried out at different firing temperatures, and the firing temperature of the first step is preferably lower than those of the subsequent firing steps.

Specifically, the first firing step, in which the mixed material powder is fired at a temperature of 1400 to 1700°C, preferably 1500 to 1700°C, to produce an intermediate product, is preferably combined with the second firing step, in which the intermediate product obtained in the first firing step is fired at a temperature of 1800 to 2000°C, preferably 1800 to 1900°C.

In general, Sr₂Al₃Si₇ON₁₃-type yellow light-emitting phosphors tend to be in the form of extremely large particles and to have insufficient luminous efficiency if the firing step is carried out only in the conventionally adopted temperature range (1800 to 2000°C). The reason why satisfying luminous efficiency cannot be obtained is presumed to be that the reactions proceed rapidly and hence are insufficiently controlled to form inhomogeneous phosphors. On the other hand, however, if the firing step is carried out only in the firing temperature range of 1400 to 1700°C, the reactions proceed so insufficiently that the aimed crystals cannot grow sufficiently.

The firing time of each step is not particularly restricted, but that of the first firing step is, for example, 15 minutes to 6 hours, preferably 30 minutes to 3 hours while that of the second firing step is, for example, 1 to 40 hours, preferably 4 to 20 hours.

In the above manner, the first firing step provides an intermediate product containing a (Sr,Ce)₂(Si,Al)₅(O,N)₈ phosphor. The intermediate product is then fired at a temperature of 1800 to 1900°C, and thereby it becomes possible to obtain a phosphor that has not been realized before, namely, a highly efficient phosphor in the form of small particles.

The method for producing the phosphor according to the embodiment comprises the first and second firing steps, and further additional firing steps can be carried out in combination. For example, after the second firing step, the fired product may be ground and then yet again fired on the same conditions as those in the second firing step.

In any of the firing steps, the firing atmosphere preferably contains oxygen in little amount. That is because of avoiding oxidation of the raw materials such as Sr₃N₂ or AIN. Specifically, the firing steps are preferably carried out in a nitrogen atmosphere, a high-pressure nitrogen atmosphere, or a deoxidized atmosphere. The atmosphere may contain hydrogen molecules in an amount of about 50 vol% or less.

After the firing steps, the product is subjected to after-treatment such as washing, if necessary, to obtain a phosphor according to the embodiment. The washing can be carried out, for example, by using pure water or acid. Examples of the acid include: inorganic acids, such as sulfuric acid, nitric acid, hydrochloric acid and hydrofluoric acid; organic acids, such as formic acid, acetic acid and oxalic acid; and mixtures thereof.

After washed with acid, the product may be subjected to post-annealing treatment, if necessary. The post-annealing treatment, which can be carried out, for example, in a reductive atmosphere containing nitrogen and hydrogen, improves the crystallinity and the luminous efficiency.

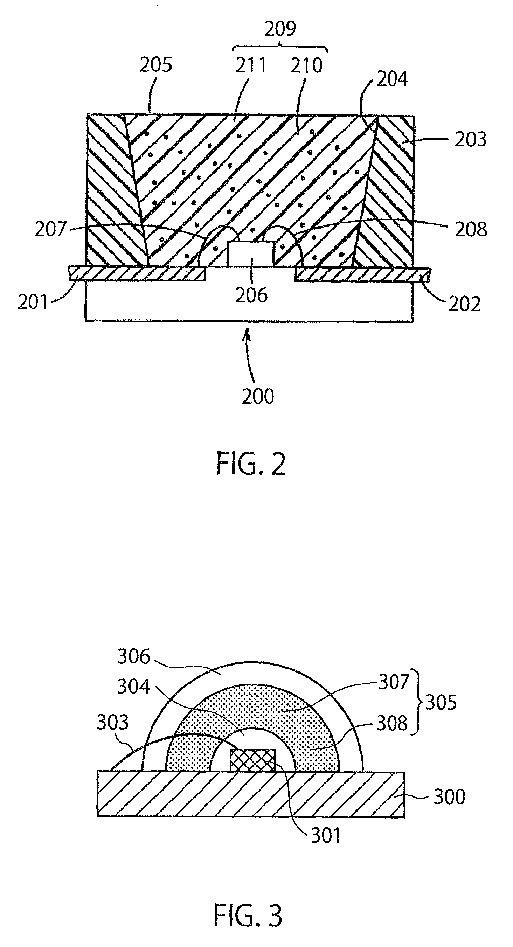

The light-emitting device according to the embodiment comprises a luminescent layer containing the above phosphor and a light-emitting element capable of exciting the phosphor. Figure 2 shows a vertical sectional view schematically illustrating a light-emitting device according to an embodiment of the present disclosure.

The light-emitting device shown in Figure 2 comprises leads 201, 202 and a package cup 203 on a substrate 200. The package cup 203 and the substrate 200 are made of resin. The package cup 203 has a concavity 205 in which the top opening is larger than the bottom. The inside wall of the concavity 205 functions as a reflective surface 204.

At the center of the nearly circular bottom of the concavity 205, there is a light-emitting element 206 mounted with Ag paste or the like. The light-emitting element 206 radiates light with a peak in the wavelength range of 400 to 500 nm. Examples of the light-emitting element 206 include light-emitting diodes and laser diodes, such as GaN type semiconductor light-emitting chips, but they by no means restrict the light-emitting element.

The p- and n-electrodes (not shown) of the light-emitting element 206 are connected to the leads 201 and 202 by way of bonding wires 207 and 208 made of Au or the like, respectively. The positions of the leads 201 and 202 can be adequately modified.

The light-emitting element 206 may be of a flip chip type in which the n- and p-electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to adopt a light-emitting element having an n-type substrate so as to produce a light-emitting device constituted as described below. In that device, an n-electrode is formed on the back surface of the n-type substrate while a p-electrode is formed on the top surface of a p-type semiconductor layer beforehand laid on the substrate. The n-electrode is mounted on one of the leads, and the p-electrode is connected to the other lead by way of a wire.

In the concavity 205 of the package cup 203, there is a luminescent layer 209 containing the phosphor 210 according to an embodiment of the present disclosure. In the luminescent layer 209, the phosphor 210 is contained in a resin layer 211 made of, for example, silicone resin in an amount of 5 to 60 wt%. As described above, the phosphor according to the embodiment comprises Sr₂Al₃Si₇ON₁₃ matrix. Since that kind of oxynitride has high covalency, the phosphor of the embodiment is generally so hydrophobic that it has good compatibility with the resin. Accordingly, scattering at the interface between the resin and the phosphor is prevented enough to improve the light-extraction efficiency.

The yellow light-emitting phosphor according to the embodiment can efficiently emit yellow light. This phosphor is used in combination with a light-emitting element radiating light with a peak in the wavelength range of 400 to 500 nm, and thereby it becomes possible to provide a white light-emitting device excellent in luminescent properties.

The size and kind of the light-emitting element 206 and the dimension and shape of the concavity 205 can be properly changed.

The light-emitting device according to an embodiment of the present disclosure is not restricted to the package cup-type shown in Figure 2, and can be freely applied to any type of devices. For example, even if the phosphor of the embodiment is used in a shell-type or surface-mount type LED, the same effect can be obtained.

Figure 3 shows a vertical sectional view schematically illustrating a light-emitting device according to another embodiment of the present disclosure. In the shown device, p- and n-electrodes (not shown) are formed at the predetermined positions on a heat-releasing insulating substrate 301, and a light-emitting element 302 is placed thereon. The heat-releasing insulating substrate 301 is made of, for example, AIN.

On the bottom of the light-emitting element 302, one of the electrodes of the element is provided and electrically connected to the n-electrode of the heat-releasing insulating substrate 301. The other electrode of the light-emitting element 302 is connected to the p-electrode (not shown) on the heat-releasing insulating substrate 301 by way of a gold wire 303. The light-emitting element 302 is a light-emitting diode radiating light with a peak in the wavelength range of 400 to 500 nm.

The light-emitting element 302 is successively domed with an inner transparent resin layer 304, a luminescent layer 305 and an outer transparent resin layer 306 in this order. The inner and outer transparent resin layers 304 and 306 are made of, for example, silicone resin. In the luminescent layer 305, the yellow light-emitting phosphor 307 according to the embodiment is dispersed in a resin layer 308 made of, for example, silicone resin.

In the production process of the light-emitting device shown in Figure 3, the luminescent layer 305, which contains the yellow light-emitting phosphor of the embodiment, can be easily formed by use of techniques such as vacuum printing and drop-coating from a dispenser. Further, since positioned between the inner and outer transparent resin layers 304 and 306, the luminescent layer 305 also has the function of improving the extraction efficiency.

The luminescent layer in the light-emitting device of the embodiment may contain not only the yellow light-emitting phosphor of the embodiment but also another phosphor emitting green luminescence under excitation by blue light and still another phosphor emitting red luminescence under excitation by blue light. If comprising that luminescent layer, the produced light-emitting device is further improved in color rendering properties. Those phosphors emitting light in different colors may be individually contained in different luminescent layers. Specifically, it is possible to laminate a luminescent layer containing the yellow light-emitting phosphor, another luminescent layer containing the green light-emitting phosphor, and still another luminescent layer containing the red light-emitting phosphor.

Even when excited by UV light with a peak in the wavelength range of 250 to 430 nm, the yellow light-emitting phosphor of the embodiment radiates yellow luminescence. Accordingly, the phosphor of the embodiment can be combined with, for example, another phosphor emitting blue light (peak wavelength: 400 to 490 nm) under excitation by UV light and a light-emitting element such as a UV light-emitting diode, to produce a white light-emitting device. In that white light-emitting device, the luminescent layer may contain not only the yellow light-emitting phosphor of the embodiment but also a phosphor emitting luminescence with a peak in another wavelength range under excitation by UV light. That phosphor is, for example, a phosphor emitting red light under excitation by UV light or a phosphor emitting green light under excitation by UV light.

As described above, the phosphor according to the embodiment can efficiently emit yellow light. That yellow light-emitting phosphor of the embodiment can be combined with a light-emitting element radiating light with a peak in the wavelength range of 250 to 500 nm, and thereby it becomes possible to produce a white light-emitting device excellent in luminescent properties by use of fewer kinds of phosphors.

The following are concrete examples of the phosphor and the light-emitting device.

### Example 1

As the raw materials containing Sr, Ce, Si and Al, Sr₃N₂, CeCl₃, Si₃N₄ and AIN were prepared and weighed out in a glove box under a nitrogen gas atmosphere. In this procedure, careful attention was paid not to contaminate the atmosphere with oxygen or water vapor. The blending amounts of Sr₃N₂, CeCl₃, Si₃N₄ and AIN were 2.902 g, 0.148 g, 5.262 g and 1.537 g, respectively. The materials were then dry-mixed in a planetary ball mill.

The obtained mixture was laid in a crucible made of boron nitride and then fired at 1700°C for 1 hour under 7.5 atm in a nitrogen atmosphere. The fired product was ground and fired again at 1800°C for 12 hours, and thereafter once more ground and fired at 1900°C for 1 hour, to obtain a phosphor of Example 1. The phosphor of Example 1 was in the form of particles having a median size of 36 µm, and had a luminous efficiency of 74%.

The obtained phosphor was in the form of yellow powder, and was observed to emit yellow luminescence when excited by black light.

The luminous efficiency was determined by the steps of: filling a quartz petri dish with 100 mg of the phosphor; exciting the phosphor by light at 450 nm; and measuring the luminescence by means of a fluorescence spectrophotometer (absolute quantum yield measurement system C9920-02G [trademark], manufactured by Hamamatsu Photonics K.K.). The excitation light at 450 nm was obtained from a xenon lamp with a monochromator.

### Example 2

The procedure of Example 1 was repeated except for changing the firing time, to obtain a phosphor of Example 2. The phosphor of Example 2 was in the form of particles having a median size of 27 µm, and had a luminous efficiency of 75%.

### Example 3

The procedure of Example 1 was repeated except for changing the firing time, to obtain a phosphor of Example 3. The phosphor of Example 2 was in the form of particles having a median size of 15 µm, and had a luminous efficiency of 71%.

### Comparative example 1

As the raw materials containing Sr, Ce, Si and Al, Sr₃N₂, CeO₂, Si₃N₄ and AIN were prepared and weighed out in a vacuum glove box. The blending amounts of Sr₃N₂, CeO₂, Si₃N₄ and AIN were 2.851 g, 0.103 g, 5.086 g and 1.691 g, respectively. The materials were then dry-mixed in an agate mortar.

The obtained mixture was laid in a crucible made of boron nitride and then fired at 1800°C for 2 hours under 7.5 atm in a nitrogen atmosphere. The fired product was taken out of the crucible, and then ground in an agate mortar. The ground product was laid again in the crucible, and fired at 1800°C for 2 hours. Those procedures of taking out, grinding and firing were further repeated twice more, to obtain a phosphor of Comparative example 1. The phosphor of Comparative example 1 was in the form of particles having a median size of 50 µm, and had a luminous efficiency of 70%.

### Emission spectra and size distributions

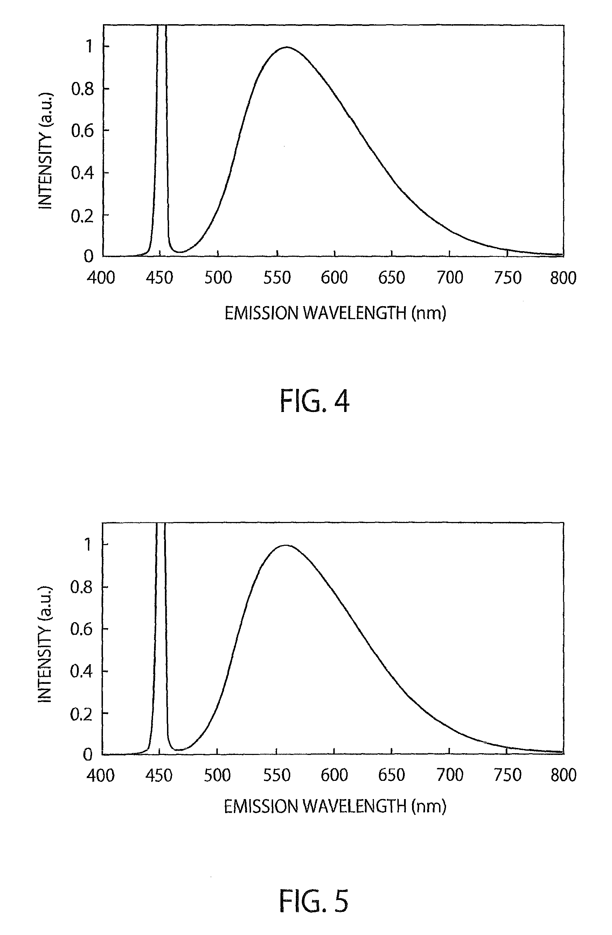

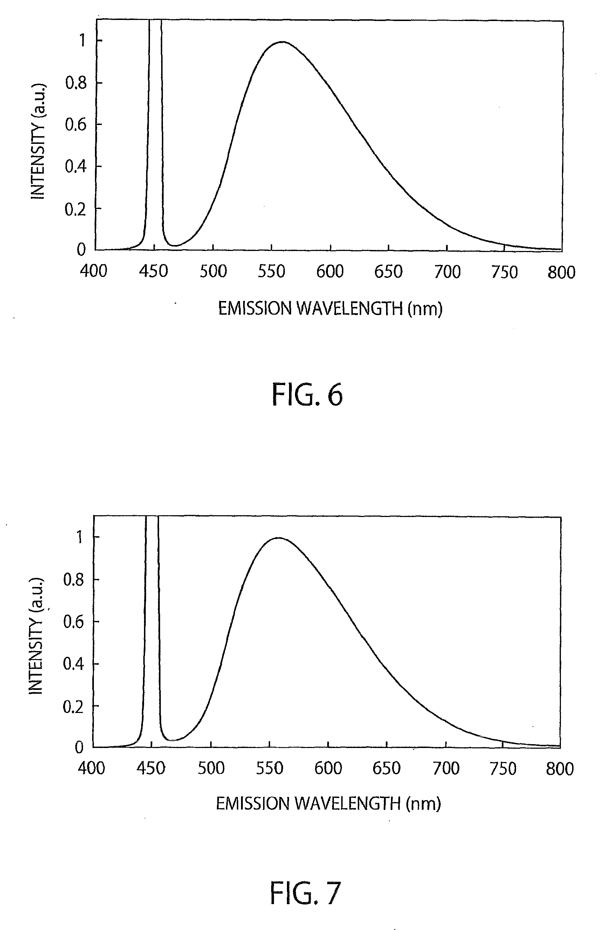

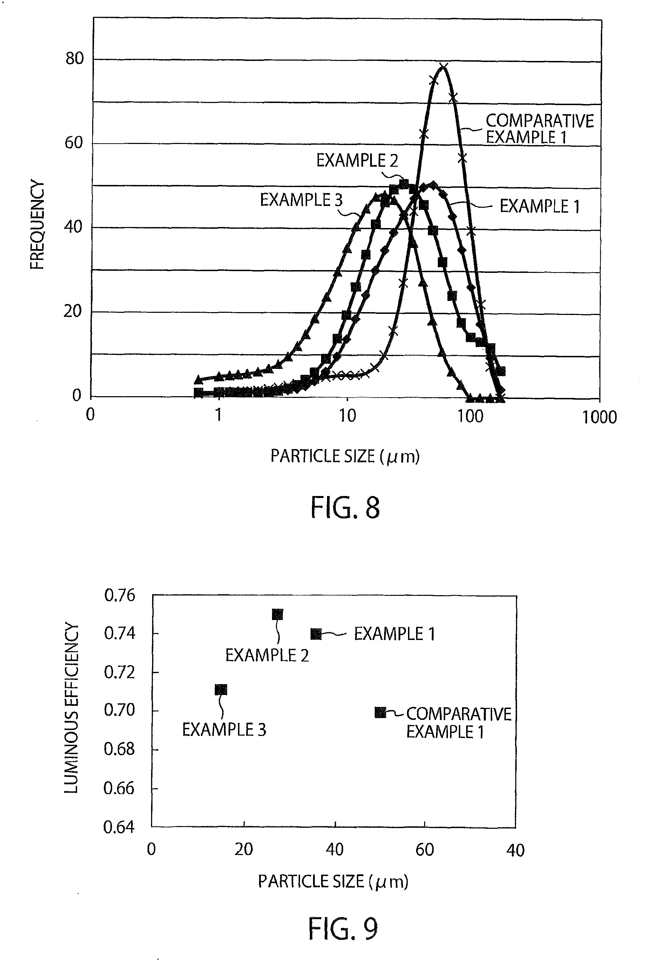

Figures 4 to 7 show emission spectra given by the phosphors of Examples 1 to 3 and Comparative example 1 (excited at 450 nm), and Figure 8 shows size distribution curves of those phosphors. Further, Figure 9 shows relation between the particle size and the luminous efficiency in each phosphor.

### Light-emitting device

The following is an example of the case where the phosphor according to the embodiment is used to produce a light-emitting device shown in Figure 3.

First, an 8-mm-square AIN substrate provided with p-and n-electrodes (not shown) thereon at the predetermined positions is prepared as the insulating substrate 300. On the substrate, a light-emitting diode showing an emission peak at 460 nm is soldered as the light-emitting element 301. One electrode of the light-emitting element 301 is provided on the bottom thereof and electrically connected to the n-electrode of the AIN substrate 300. The other electrode of the element 301 is connected to the p-electrode (not shown) of the AIN substrate 300 by way of a gold wire 303.

Subsequently, the light-emitting element 301 is successively domed with an inner transparent resin layer 304, a luminescent layer 305 and an outer transparent resin layer 306 in this order, to produce a light-emitting device of the embodiment. The inner transparent resin layer 304 is made of silicone resin, and is formed by use of a dispenser. The luminescent layer 305 is, for example, made of a transparent resin containing the phosphor of Example 1 in an amount of 15 wt%. As the transparent resin, silicone resin is adopted. The luminescent layer 305 is then covered with an outer transparent resin layer 306 made of the same silicone resin as the inner transparent resin layer 304.

The luminescent properties of this device are simulated, and, as a result, when worked with 20 mA and 3 V, the device is calculated to exhibit a color temperature of 5000K, a luminous flux efficiency of 1021 Im/W and Ra=68.

In this way, the phosphor of the embodiment is combined with a blue LED showing an emission peak at 460 nm, to produce a white light-emitting device of the embodiment. This white light-emitting device can be used as a white LED lighting apparatus excellent in luminous efficiency.

The embodiment of the present disclosure thus provides a yellow light-emitting phosphor in the form of small particles. This phosphor makes it possible to produce a white LED lighting apparatus which has high efficiency and which less suffers from chromaticity fluctuation depending on the device. The yellow light-emitting phosphor of the embodiment is combined with a blue LED, and thereby it becomes possible to obtain a white light-emitting device which has high efficiency and which less suffers from chromaticity fluctuation. Further, excellent luminescent properties are realized also by another white light-emitting device comprising a combination of the yellow light-emitting phosphor of the embodiment, a desired red light-emitting phosphor and a LED capable of exciting those phosphors and yet also by still another white light-emitting device comprising a combination of the yellow light-emitting phosphor of the embodiment, a desired red light-emitting phosphor, a desired green light-emitting phosphor and a LED capable of exciting those phosphors.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A phosphor represented by the following formula (1):
((SrₚM₁₋ₚ)₁₋ₓCeₓ)_{2y}Al_{z}Si_{10-z}OᵤN_{w} (1)
in which M is at least one of the alkaline earth metals, and p, x, y, z, u and w satisfy the conditions of
0≤p≤1,
0<x≤1,
0.8≤y≤1.1,
2≤z≤3.5,
0<u≤1,
1.5≤z-u, and
13≤u+w≤15, respectively,
wherein said phosphor exhibits an emission peak in the wavelength range of 500 to 600 nm under excitation by exciting light having a peak in the wavelength range of 250 to 500 nm; wherein said phosphor has a composition;
said phosphor is in the form of particles having a median size of 5 to 40 µm inclusive; and
said phosphor having a luminous efficiency of more than 70%.

2. The phosphor according to claim 1, wherein said M is an element selected from the group consisting of Ba, Ca and Mg.

3. The phosphor according to claim 1, having a crystal with lattice constants the differences of which from those in Sr₂Al₃Si₇ON₁₃ crystal are within a range of ±15%.

4. The phosphor according to claim 1, having a crystal with chemical bond lengths of M-N and M-O the differences of which from those of Sr-N and Sr-O, respectively, in Sr₂Al₃Si₇ON₁₃ are within a range of ±15%.

5. The phosphor according to claim 1, having a crystal belonging to a Sr₂Al₃Si₇ON₁₃-type crystal.

6. A phosphor represented by the following formula (1):
((SrₚM₁₋ₚ)₁₋ₓCeₓ)_{2y}Al_{z}Si_{10-z}OᵤN_{w} (1)
in which M is at least one of the alkaline earth metals, and p, x, y, z, u and w satisfy the conditions of
0≤p≤1,
0<x≤1,
0.8≤y≤1.1,
2≤z≤3.5,
0<u≤1,
1.5≤z-u, and
13≤u+w≤15, respectively;
wherein said phosphor is produced by the steps of
mixing
a material containing Sr selected from a nitride, a silicide ,a carbide or a carbonate of Sr,
a material containing M selected from a nitride, a silicide, a carbide or a carbonate of M,
a material containing Al selected from a nitride, an oxide or a carbide of Al,
a material containing Si selected from a nitride, an oxide or a carbide of Si, and
a material containing Ce selected from a chloride, an oxide, a nitride or a carbonate of Ce,
to prepare a mixture,
subjecting the mixture to first firing, and then
subjecting the fired product to second firing at a higher temperature;
said phosphor exhibiting an emission peak in the wavelength range of 500 to 600 nm under excitation by light having a peak in the wavelength range of 250 to 500 nm.

7. A light-emitting device comprising
a light-emitting element radiating light with a peak in the wavelength range of 250 to 500 nm, and
a luminescent layer containing the phosphor according to claim 1.

8. A light-emitting device comprising
a light-emitting element radiating light with a peak in the wavelength range of 250 to 430 nm, and
a luminescent layer containing the phosphor according to claim 1 and another phosphor that exhibits an emission peak in the wavelength range of 400 to 490 nm under excitation by light from said light-emitting element.

9. A method for producing the phosphor according to claim 1, comprising the steps of
mixing
a material containing Sr selected from a nitride, a silicide, a carbide or a carbonate of Sr,
a material containing M selected from a nitride, a silicide, a carbide or a carbonate of M,
a material containing Al selected from a nitride, an oxide or a carbide of Al,
a material containing Si selected from a nitride, an oxide or a carbide of Si, and
a material containing Ce selected from a chloride, an oxide, a nitride or a carbonate of Ce,
to prepare a mixture,
subjecting said mixture to first firing, and then subjecting the fired product to second firing at a temperature higher than that in said first firing.

10. The method according to claim 9, wherein said first and second firing steps are carried out at temperatures of 1400 to 1700°C and 1800 to 2000°C, respectively.

11. The method according to claim 9, wherein said firing steps are throughout or partly carried out under an increased pressure of 5 atm or more.

12. The method according to claim 9, wherein an intermediate product containing a (Sr,Ce)₂(Si,Al)₅(O,N)₈ phosphor is produced in said first firing step.
